Europäisches Patentamt

European Patent Office

Office européen des brevets

(11) Veröffentlichungsnummer: **0 255 587**
**A2**

(12) **EUROPÄISCHE PATENTANMELDUNG**

(21) Anmeldenummer: **87108519.7**

(22) Anmeldetag: **12.06.87**

(51) Int. Cl.4: **H05K 9/00**

(30) Priorität: **25.07.86 CH 2998/86**
**22.09.86 CH 3769/86**

(43) Veröffentlichungstag der Anmeldung:
**10.02.88 Patentblatt 88/06**

(84) Benannte Vertragsstaaten:
**AT BE CH DE ES FR GB GR IT LI LU NL SE**

(71) Anmelder: **Menor AG**
**Hendschikerstrasse 1**
**CH-5605 Dottikon(CH)**

(72) Erfinder: **Tschopp, Rudolf**
**Hölibachstrasse 101**
**CH-8912 Obfelden(CH)**

(74) Vertreter: **Fillinger, Peter, Dr.**
**Rütistrasse 1a**
**CH-5400 Baden(CH)**

(54) **Dichtung gegen hochfrequente Ströme sowie gegen hochfrequente Ströme abgedichteter Metallschrank.**

(57) Mit der Dichtung soll der Zwischenraum (8) zwischen dem Türblatt (2) und dem Türrahmen (I) gegen hochfrequente Ströme abgedichtet werden. Dabei ist die eine Seite der Dichtung (3) dem Umgebungsraum und die andere Seite dem durch die Türe abgeschlossenen Schutzraum zugewandt. Die Dichtung (3) weist einen federelastischen, elektrisch leitenden Materialstreifen (2I) auf, der mit einem ersten, eine Kontaktkante oder Kontaktfläche bildenden seitlichen Längsbereich (9) elastisch federnd gegen den an diesen ersten Längsbereich (9) angrenzenden zweiten Längsbereich (M) biegbar ist. In diesem zweiten Längsbereich (M) weist der Materialstreifen (2I) ein für eine kontaktschlüssige Verbindung mit einer Rippe (7) geeignetes Profil (I0, 20) auf.

Fig. 1

EP 0 255 587 A2

## Dichtung gegen hochfrequente Ströme sowie gegen hochfrequente Ströme abgedichteter Metallschrank

Die vorliegende Erfindung bezieht sich auf eine Dichtung gemäss dem Oberbegriff des Anspruches l.

Um das Innere eines Metallschranks vor dem Eindringen von den Schrank umgebenden hochfrequenten Strömen schützen zu können, sind aus elektrisch leitenden Drähten geflochtene Dichtungsschläuche bekannt, welche beim Schliessen der Türe im Zwischenraum zwischen Türblatt und Türrahmen eingeklemmt werden. Dies ist besonders von Bedeutung, wenn im Schrank eine empfindliche Schaltelektronik untergebracht ist. Umgekehrt kann sie auch das Austreten hochfrequenter Ströme verhindern, wenn im Schrank Hochfrequenzsender untergebracht sind.

Elektrisch leitende Drahtgeflechtschläuche haben den Nachteil, dass ihre Montage am Türblatt oder Türrahmen eines Schrankes zeitbeanspruchend und ihre rein elastische Verformbarkeit gering ist. Eine hinreichende Dichtfähigkeit ist damit schwer zu erreichen. Zudem ist bei solchen Dichtungen eine vergleichsweise grosse Schliesskraft erforderlich.

Die vorliegende Erfindung stellt sich die Aufgabe, eine Dichtung der genannten Art zu schaffen, welche diese Nachteile beseitigt.

Erfindungsgemäss wird diese Aufgabe gelöst durch die kennzeichnenden Merkmale des Anspruches l.

Die Erfindung hat den Vorteil, dass sich beim Öffnen und Schliessen der Türe jeweils die - schrank-und dichtungsseitigen Kontaktflächen reiben und dabei reinigen.

Bei der bevorzugten Dichtung gemäss Anspruch 5 sind der elektrisch leitende Metallstreifen und die mit ihm zusammenwirkenden Kontaktflächen gegen korrosive Medien und gegen Staub im Umgebungsraum geschützt, was die Schutzfunktion der Dichtung für lange Zeit gewährleistet.

Anhand der beiliegenden schematischen Zeichnung wird die Erfindung beispielsweise beschrieben. Es zeigen:

Fig. l bis 3 drei Ausführungsbeispiele ohne gummielastischen Streifen und die

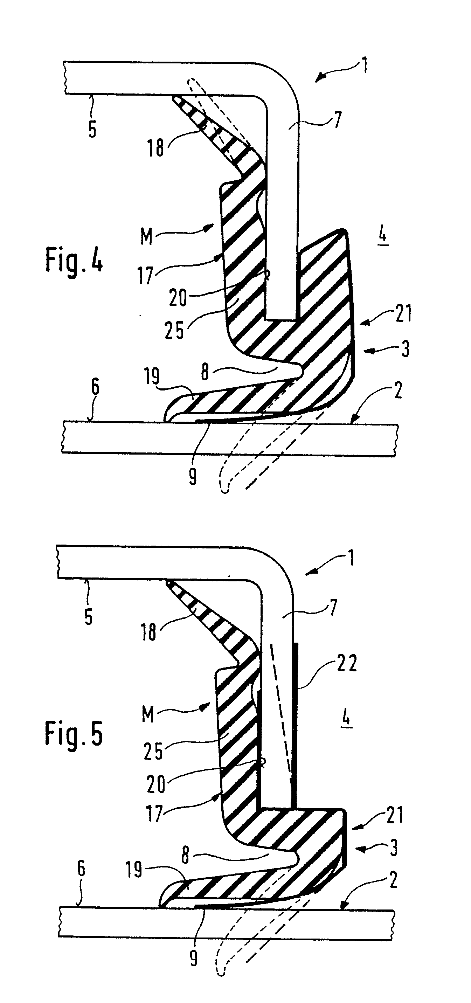

Fig. 4 bis 7 vier Ausführungsbeispiele mit gummielastischem Streifen.

Alle Figuren zeigen einen Ausschnitt aus einem Querschnitt durch einen Schrank mit Türe.

Fig. l zeigt von der geschlossenen Türe den Türrahmen l, das Türblatt 2 und eine Dichtung 3. Die vom Türrahmen l umgebene Türöffnung ist mit der Hinweisziffer 4 bezeichnet. Sie ist von einer am Türrahmen l angeordneten ebenen Dichtfläche 5 umgeben, der mit Abstand eine zweite parallele Dichtfläche 6 am Türblatt 2 gegenüberliegt. Vor der Dichtfläche 5 ragt rechtwinklig eine Rippe 7 gegen das Türblatt 2 weg und endet mit Abstand vor diesem, so dass ein Zwischenraum 8 zwischen Türrahmen und Türblatt frei bleibt. Die Rippe 7 kann einstückig mit dem übrigen Türrahmen l gefertigt oder mit diesem verschweisst sein. Auf die Rippe 7 aufgesteckt ist die Dichtung 3, um den Zwischenraum 8 gegen den Durchtritt hochfrequenter Ströme abzudichten. Die Dichtung 3 weist einen federelastischen Blechstreifen aus Edelstahl oder einem anderen elektrisch-resp. HF-leitenden Material auf wie Beryllium-Bronce oder dgl., der mit einem seitlichen, einen Lappen bildenden Längsbereich 9 den Zwischenraum 8 abschliesst. Im mittleren Längsbereich M bildet der Blechstreifen 3 ein U-Profil mit gegeneinander geneigten U-Schenkeln, welche federelastisch aufspreizbar sind und eine Klemmnut l0 bilden.

Die Dichtung 3 ist mit der Klemmnut l0 auf die Rippe 7 aufgesteckt und an dieser infolge der elastischen Reaktionskraft kraftschlüssig gehalten. Ist die Türe offen, entspannt sich der Lappen 9 und nimmt die mit gestrichelter Linie gezeigte Lage ein. Beim Einschwenken des Türblattes 2 kommt die Dichtfläche 6 zuerst gegen die freie Längskante des Lappens 9 zu liegen und biegt diesen allmählich in die mit ausgezogenem Strich gezeigte Stellung, in welcher die Türe geschlossen ist. Dabei gleitet und reibt die freie Längskante auf der Dichtfläche 6, wodurch einer Korrosion oder Verschmutzung derselben durch das Öffnen und Schliessen der Türe entgegen gewirkt wird. Ein guter Kontakt zwischen der Dichtung 3 und dem Türblatt 2 wird dadurch bei geschlossener Türe erreicht. Durch das Biegen des Lappens 9, wird die Dichtung 3 zunehmend gegen die Fläche ll der Rippe 7 gedrückt, wo sich durch das Öffnen und Schliessen der Türe im Berührungsbereich zwischen der Dichtung 3 und der Fläche ll ebenfalls eine reibende Relativbewegung ergibt, welche einem Verschmutzen der Kontaktflächen entgegenwirkt. Im Bedarfsfall kann die Dichtung 3 mit der Rippe 7 durch Punktschweissen oder dgl. verbunden sein. Die Dichtung 3 ist weiter anschliessend an den mit einem U-Profil versehenen mittleren Längsbereich M, mit einem ebenfalls als Lappen ausgebildeten Längsbereich l2 versehen, der durch das Aufstecken der Dichtung 3 auf die Rippe 7 leicht einwärts gegen den Lappen 9 gebogen wird und dadurch unter seiner Rückstellkraft gegen die Dichtfläche 5 anliegt. Beim Öffnen und Schliessen der Türe entsteht auch längs der Berührungslinie zwischen dem Lappen l2 und der Dichtfläche 5 eine geringe Bewegung, welche einem Verschmutzen oder Korrodieren der Kontaktfläche entgegenwirkt.

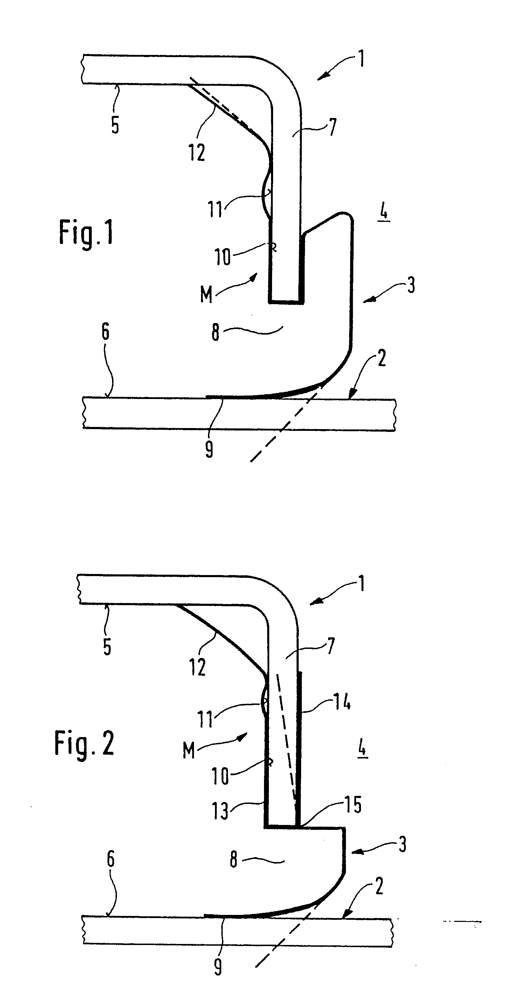

Beim Ausführungsbeispiel nach Fig. 2 ist das U-Profil im mittleren Längsbereich M durch einen Abschnitt l3 und einen diesem zugeordneten, bandförmigen Federschenkel l4 gebildet, der bei l5 mit dem restlichen Teil der Dichtung durch Löten oder Schweissen verbunden ist. Im entspannten Zustand ist der Schenkel l4 gegen den Abschnitt l3 geneigt und wird beim Aufstecken der Dichtung 3 auf die Rippe 7 elastisch federnd aufgespreizt, so dass eine kraftschlüssige Verbindung ent steht. Die übrigen Teile der Dichtung 3 sind gleich ausgebildet wie beim Beispiel nach Fig. l.

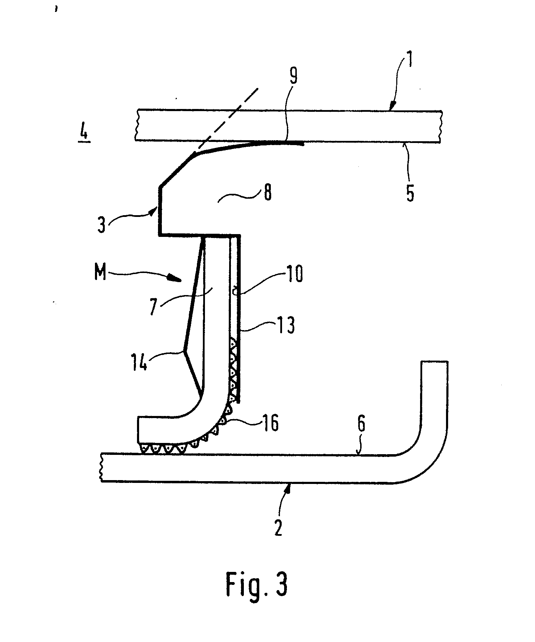

Das Beispiel nach Fig. 3 unterscheidet sich im wesentlichen dadurch, dass der den Lappen l2 bildende Längsbereich fehlen kann. Zudem ist hier die Rippe 7 als Schenkel eines L-Profils auf die Dichtfläche 6 des Türblattes 2 geschweisst. Zwischen dem gegen das Türblatt 2 liegenden Schenkel des L-Profils ist eine hochfrequente Ströme leitendes Geflecht l6 mit angeschweisst, so dass eine grosse und innige Kontaktfläche zwischen der Rippe 7 und dem Türblatt 2 entsteht. Dieses Metallgeflecht erstreckt sich bis unter den Abschnitt l3 der Dichtung 3, der unter der Wirkung des vorgespannten Federschenkels l4 dagegen gedrückt wird und dadurch eine hinreichende Kontaktfläche gewährleistet.

Die Querschnittsformen im mittleren Bereich des Profils 3 einerseits und der Rippe 7 anderseits können so gestaltet sein, dass nebst der kraftschlüssigen Verbindung zusätzlich ein Formschluss im Sinne einer Rasterverbindung entsteht.

Fig. 4 zeigt von der geschlossenen Türe den Türrahmen l, das Türblatt 2 und die Dichtung 3. Die Türöffnung ist mit der Hinweisziffer 4 bezeichnet. Sie ist von einer am Türrahmen l angeordneten, ebenen Dichtfläche 5 umgeben, der mit Abstand eine zweite parallele Dichtfläche 6 am Türblatt 2 gegenüberliegt. Von der Dichtfläche 5 ragt rechtwinklig eine Rippe 7 gegen das Türblatt 2 weg und endet mit Abstand vor diesem, so dass ein Zwischenraum 8 frei bleibt. Die Rippe 7 kann einstückig mit dem übrigen Türrahmen l gefertigt oder mit diesem verschweisst sein. Auf die Rippe 7 aufgesteckt ist die Dichtung 3, um den Zwischenraum 8 abzudichten. Diese weist zusätzlich auf der dem Umgebungsraum zugewandten Seite einen gummielastischen Streifen l7 mit zwei Dichtungslappen l8, l9 auf, die gegen einen mittleren Längsbereich M in Form eines Steges 25 konvergieren und einstückig mit diesem gefertigt sind.

Auf der dem Umgebungsraum abgewandten Seite bildet der Steg 25 eine Klemmnut 20, in welche die Rippe 7 hineingreift und an der die Dichtung 3 kraft-bzw. reibschlüssig gehalten ist. Beim Aufstecken der Dichtung 3 wird der Dichtungslappen l8 mit der freien Längsseite gegen die Dichtfläche 5 gedrückt und elastisch gebogen, so dass er unter Vorspannung gegen diese anliegt. Wird nach dem Aufstecken der Dichtung 3 die Türe geschlossen, biegt das Türblatt 2 mit der Dichtfläche 6 die freie Längsseite des Dichtungslappens l9 elastisch nach innen, so dass deren Randlippe unter Vorspannung dicht am Türblatt 2 anliegt. Auf der dem geschützten Raum zugewandten Seite des gummielastischen Streifens l7 weist die Dichtung 3 weiter einen federelastischen Streifen 2l aus Edelstahl oder einem anderen elektrisch resp. HF-leitenden Material wie Beryllium-Bronce auf, das rückseitig des den Zwischenraum 8 verschliessenden, gummielastischen Streifens l7 mit einem Längsbereich 9 einen weiteren Dichtungslappen bildet, der im wesentlichen parallel zum Dichtungslappen l9 verläuft und mit diesem beim Schliessen der Türe vom Türblatt 2 nach innen gebogen wird. Die Kontaktkante oder Kontaktfläche des seitlichen Längsbereichs 9 liegt dadurch auch unter federelastischer Vorspannung gegen die Dichtfläche 6 des Türblatts 2 an. Der angrenzende Längsbereich des Streifens 2l greift in die Klemmnut 20 und bildet deren eine Flanke und wird unter der elastischen Verformungsspannung des Steges 25 kontaktschlüssig gegen die Rippe 7 gedrückt. Der Streifen 2l sperrt somit den Zwischenraum 8 gegen äussere und innere HF-Ströme und hat linien-oder bandförmige Kontaktflächen mit den anschliessenden Schrankelementen. Der Streifen 2l ist mit dem Steg 25 durch Kleben, durch Reiboder Kraftschluss, durch Koextrudieren oder dgl. verbunden.

Die Erfindung hat den Vorteil, dass beim Spannen und Entspannen des Streifens 2l, ein Vorgang der sich beim Öffnen und Schliessen der Türe jeweils wiederholt, sich seine Kontaktkanten bzw. Kontaktflächen an der Rippe 7 bzw. der Dichtfläche 6 reiben, was einer Korrosion oder Verschmutzung der Kontaktflächen entgegenwirkt. Dadurch, dass der Streifen 2l auf der dem geschützten Raum zugewandten Seite des Steges 25 angeordnet ist, ist er zudem vor äusserer Staubatmosphäre oder äusseren korrosiven Gasen geschützt, welche die Kontaktflächen verschmutzen oder angreifen und dadurch inaktivieren können. Ein weiterer Vorteil der Erfindung liegt darin, dass sie einfach montierbar und, im Falle einer Beschädigung, einfach auswechselbar ist.

Beim Ausführungsbeispiel nach Fig. 5 bezeichnen gleiche Hinweisziffern gleiche oder äquivalente Teile wie beim Beispiel nach Fig. 4. In Abweichung zu diesem wird hier die Klemmnut 20 vorwiegend durch den Streifen 2l getildet, an welchem zu diesem Zweck ein Federschenkel 22 angeschweisst ist. Im entspannten Zustand ist der Federschenkel 22 gegen die andere Nutflanke geneigt und wird beim Aufstecken der Dichtung auf die Dichtleiste 7 federelastisch vorgespannt.

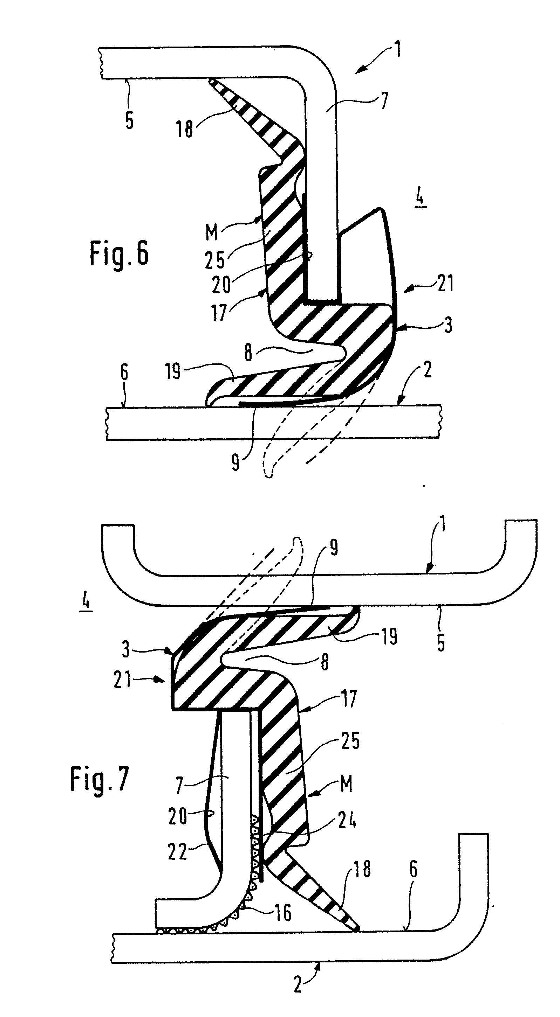

Beim Ausführungsbeispiel nach Fig. 6 ist die Klemmnut 20 in den Streifen 2l eingeformt.

Bei den Ausführungsformen nach den Fig. 5 und 6 ist der Streifen 2l im Bereich des Steges M vorzugsweise verklebt.

Die Rippe 7 kann anstatt am Türrahmen l' angeordnet am Türblatt 2 als Schenkel eines L-Profils rechtwinklig zur Dichtfläche 6 angeschweisst sein, wie dies beim Beispiel nach Fig. 7 der Fall ist. Zwischen dem gegen das Türblatt 2 liegenden Schenkel des L-Profils ist ein hochfrequente Ströme leitendes Metallgeflecht l6 mit angeschweisst, welches sich bis unter den Federschenkel 24, der unter Wirkung des vorgespannten Federschenkels 22 dagegen gedrückt wird.

## Ansprüche

l. Dichtung für Türen, Klappen und dgl., die dazu bestimmt ist, im geschlossenen Zustand den Zwischenraum (8) zwischen dem Türblatt (2) und dem Türrahmen (l) gegen hochfrequente Ströme abzudichten, wobei die eine Seite der Dichtung (3) dem Umgebungsraum und die andere Seite dem durch die Türe abgeschlossenen Schutzraum zugewandt ist, dadurch gekennzeichnet, dass die Dichtung (3) einen federelastischen, elektrisch leitenden Materialstreifen (2l) aufweist, der mit einem ersten, eine Kontaktkante oder Kontaktfläche bildenden seitlichen Längsbereich (9) elastisch federnd gegen den an diesen ersten Längsbereich (9) angrenzenden zweiten Längsbereich (M) biegbar ist, und dass der Materialstreifen (2l) in diesem zweiten Längsbereich (M) ein für eine kontaktschlüssige Verbindung mit einer Rippe (7) geeignetes Profil (l0, 20) aufweist.

2. Dichtung nach Anspruch l, dadurch gekennzeichnet, dass sie im zweiten Längsbereich (M) für eine kontaktschlüssige Verbindung im wesentlichen ein U-Profil (l0) mit gegeneinander geneigten U-Schenkeln aufweist, welche U-Schenkel elastisch federnd aufspreizbar sind und eine Klemmnut (l0, 20) bilden.

3. Dichtung nach Anspruch l oder 2, dadurch gekennzeichnet, dass an den zweiten Längsbereich (M) ein dritter, eine Kontaktkante oder Kontaktfläche bildender Längsbereich (l2) anschliesst, der elastisch federnd gegen den zweiten Längsbereich (M) biegbar ist.

4. Dichtung nach einem der Ansprüche 2 oder 3, dadurch gekennzeichnet, dass die kontaktschlüssige Verbindung im zweiten Längsbereich (M) zusätzlich für eine kraft-und/oder formschlüssige Verbindung geeignet ist.

5. Dichtung nach Anspruch l, dadurch gekennzeichnet, dass auf der dem Umgebungsraum zuzuwendenden Seite des elektrisch leitenden Materialstreifens (2l) ein gummielastischer Streifen (l7) vorhanden ist, dass dieser gummielastische Streifen (l7) in zwei sich schneidenden Ebenen liegende Dichtungslappen (l8, l9) aufweist, die längs den einander näher liegenden Seiten durch einen Steg (25) verbunden sind, welcher Steg (25) auf der dem elektrisch leitenden Materialstreifen (2l) zugewandten Seite ein für eine kraftschlüssige Verbindung mit einer Rippe (7) geeignetes Profil bildet.

6. Dichtung nach den Ansprüchen 2 und 5, dadurch gekennzeichnet, dass die Klemmnut (20) durch den elektrisch leitenden Metallstreifen (2l) und/oder durch den gummielastischen Streifen (l7) gebildet ist.

7. Metallschrank, der bei geschlossener Türe zwei parallele, die Türöffnung (4) umgebende, ebene Dichtflächen (5, 6) aufweist, von denen eine am Türrahmen (l) und die andere am Türblatt (2) oder umgekehrt angeordnet ist, wobei eine der beiden Dichtflächen (5, 6) eine ebenfalls um die Türöffnung (4) herumlaufende Rippe (7) aufweist, dadurch gekennzeichnet, dass der Zwischenraum (8) zwischen der Rippe (7) und der gegenüberliegenden Dichtfläche (5 bzw. 6) durch einen federelastischen, elektrisch leitenden Materialstreifen (3) dicht geschlossen ist (Fig. l bis 3), welcher Materialstreifen (3) mit einer Seite dem Umgebungsraum und mit der anderen Seite dem Schrankinneren zugewandt ist und mit einem ersten eine Kontaktkante oder Kontaktfläche bildenden seitlichen Längsbereich (9) elastisch federnd gegen einen angrenzenden zweiten Längsbereich (M) biegbar ist, dass der Materialstreifen (3) in diesem zweiten Längsbereich (M) durch ein für eine kontaktschlüssige Verbindung geeignetes Profil mit der Rippe (7) verbunden ist, und dass der erste Längsbereich (9) durch die durch das Schliessen der Türe bewirkte Rückstellkraft mit der Kontaktkante oder Kontaktfläche mit der genannten Dichtfläche (5 bzw. 6) in Anlage ist, wogegen der zweite Bereich (M) in Berührungskontakt mit der Rippe (7) steht.

8. Metallschrank nach Anspruch 7, dadurch gekennzeichnet, dass der zweite Längsbereich (M) im wesentlichen ein U-Profil mit gegeneinander geneigten U-Schenkeln aufweist, und dass die U-Schenkel durch die umlaufende Rippe (7) aufgespreizt und kraftschlüssig mit dieser verbunden sind.

9. Metallschrank nach Anspruch 7 oder 8, dadurch gekennzeichnet, dass an den zweiten Längsbereich (M) ein dritter, eine Kontaktkante oder Kontaktfläche bildender Längsbereich (12) anschliesst, der elastisch federnd gegen den zweiten Längsbereich (M) biegbar und mit der Kontaktkante oder Kontaktfläche gegen die zweite Dichtfläche (5 bzw. 6) anliegt.

10. Metallschrank nach einem der Ansprüche 6 bis 9, dadurch gekennzeichnet, dass die Rippe (7) mindestens teilweise mit einem HF-Ströme leitenden Vlies, Gewebe, Geflecht oder dgl. (16) überzogen ist, und dass wenigstens einer der U-Schenkel (13) in Anlagekontakt mit dem Geflecht (16) ist.

11. Metallschrank nach Anspruch 9, dadurch gekennzeichnet, dass die Rippe (7) ein L-Profil aufweist und mit einem ihrer Profilschenkel fest mit einer der Dichtflächen (6) verbunden ist, und dass das Geflecht (16) sich bis zwischen den Profilschenkel und die Dichtfläche (6) erstreckt.

12. Metallschrank nach einem der Ansprüche 7 bis 11, dadurch gekennzeichnet, dass auf der dem Umgebungsraum zugewandten Seite des elektrisch leitenden Materialstreifens (21) ein gummielastischer Streifen (17) vorhanden ist, dass dieser gummielastische Streifen (17) in zwei sich - schneidenden Ebenen liegende Dichtungslappen (18, 19) aufweist, die längs den einander näher liegenden Seiten durch einen Steg (25) verbunden sind, welcher Steg (25) auf der dem elektrisch leitenden Materialstreifen (21) zugewandten Seite ein für eine kraftschlüssige Verbindung mit einer Rippe (7) geeignetes Profil bildet.

13. Metallschrank nach Anspruch 12, dadurch gekennzeichnet, dass die Klemmnut (20) durch den elektrisch leitenden Metallstreifen (21) und/oder durch den gummielastischen Streifen (17) gebildet ist.

Fig.1

Fig. 2

Fig. 3

Fig. 4

Fig. 5

Fig.6

Fig.7